(19)

Europäisches
Patentamt
European
Patent Office
Office européen
des brevets

(11)     **EP 1 473 383 B1**

(12)                           **EUROPEAN PATENT SPECIFICATION**

(45) Date of publication and mention
of the grant of the patent:
**15.08.2012  Bulletin 2012/33**

(51) Int Cl.:
*C23C 16/22* *(2006.01)*      *C23C 16/02* *(2006.01)*

(21) Application number: **04447106.8**

(22) Date of filing: **29.04.2004**

(54) **Method for producing polycrystalline silicon germanium suitable for micromachining**

Verfahren zur Herstellung einer zur Mikrobearbeitung geeigneten polykristallinen Silizium-Germanium-Schicht

Méthode de production d'une couche polycristalline de silicium germanium adaptée au micro-usinage

(84) Designated Contracting States:
**AT BE BG CH CY CZ DE DK EE ES FI FR GB GR HU IE IT LI LU MC NL PL PT RO SE SI SK TR**

(30) Priority: **28.05.2003 EP 03447127**
**29.04.2003 US 466844 P**

(43) Date of publication of application:
**03.11.2004  Bulletin 2004/45**

(73) Proprietor: **IMEC**
**3001 Leuven (BE)**

(72) Inventor: **Witvrouw, Ann**
**3020 Herent (BE)**

(74) Representative: **Bird, Ariane et al**
**Bird Goën & Co NV**
**Klein Dalenstraat 42A**
**3020 Winksele (BE)**

(56) References cited:
**WO-A-01/74708        US-A1- 2001 032 986**
**US-A1- 2003 071 307    US-B1- 6 448 622**

**Description**

**Field of the invention**

The invention is related to methods to obtain as-deposited, low-stress and low resistivity polycrystalline SiGe layers as well as semiconductor devices utilizing the SiGe layers. For example, these layers can be used in Micro Electro-Mechanical Systems (MEMS) devices or micro-machined structures.

**Backcground of the invention**

Micro Electro Mechanical Systems (MEMS) are used in a wide variety of systems such as accelerometers, gyroscopes, infrared detectors, micro turbines, etc. For high volume applications, fabrication costs can possibly be reduced by monolithic integration of MEMS with the driving electronics. Also, for 2D imaging applications (e.g. detectors, displays) monolithic integration of MEMS and CMOS processing is a good solution as this simplifies the interconnection issues The easiest approach for monolithic integration is post-processing MEMS on top of the driving electronics, as this does not introduce any change into standard fabrication processes used for realising the driving electronics. It also allows the realisation of a more compact micro-system. This is not possible if the MEMS-device is produced prior to the formation of the driving electronics. On the other hand, post processing imposes an upper limit on the fabrication temperature of MEMS to avoid any damage or degradation in the performance of the driving electronics. This temperature is typically 450°C An overview of the several approaches with respect to the integration of driving electronics and MEMS devices can be found in 'Why CMOS-integrated transducers? A review', Microsystem Technologies, Vol 6 (5), p 192-199, 2000, by A. Witvrouw et al.

For many micromachined devices, such as transducers and other free-standing structures, the mechanical properties of the applied thin films can be critical to their success. For example, stress or stress gradients can cause free-standing thin-film structures to warp to the point that these structures become useless. Such thin film layers have ideally a low stress and a zero stress gradient If the stress is compressive (minus-sign (-)), structures can buckle If the stress is too high tensile (plus-sign (+)), structures can break. If the stress gradient is different from zero, microstructures can deform, e.g. cantilevers can bow

Polycrystalline silicon (poly Si) has been widely used for MEMS applications. The main disadvantage of this material is that it requires high processing temperatures, higher than 800°C, to achieve the desired physical properties especially stress as explained in "Strain studies in LPCVD polysilicon for surface micromachined devices," Sensors and Actuators A (physical), A77 (2), p. 133-8 (1999), by J. Singh S. Chandra et al. This means that poly Si MEMS applications can not be used for integration with CMOS if the CMOS is processed before the MEMS device.

Polycrystalline silicon germanium (poly SiGe) is known in the art as an alternative to poly Si as it has similar properties. The presence of germanium reduces the melting point of the silicon germanium alloy and hence the desired physical properties are expected to be realised at lower temperatures, allowing the growth on low-cost substrates such as glass Depending on the germanium concentration and the deposition pressure, the transition temperature from amorphous to polycrystalline can be reduced to 450°C, or even lower, compared to 580°C for CVD poly Si.

A functional poly SiGe layer for instance for use in microstructure devices as for instance in gyroscopes, accelerometers, micro-mirrors, resonators, etc (typically 3 $\mu m$ to 12 $\mu m$ thick) requires low-stress (<20$MPa$ compressive and < 100$MPa$ tensile) and low electrical resistivity. An important issue for industrial applicability is moreover that it must be possible to produce these layers with a relative high deposition rate A reasonably small variance of characteristics between different points on the wafer should be achieved

WO 01/74708 deals with the development of low-stress poly-SiGe layers under different deposition parameters. Some deposition parameters studied are for example deposition temperature, concentration of semiconductors (*e.g.*, the concentration of Silicon and Germanium in a $Si_xGe_{1-x}$ layer, with x being the concentration parameter), concentration of dopants (*e.g.*, the concentration of Boron or Phosphorous), amount of pressure and use of plasma.

Fast deposition methods such as PACVD (Plasma Assisted CVD) or PECVD (Plasma Enhanced CVD) having a typical deposition rate > 100 nm/min, normally result in amorphous layers with high stress and high resistivity at temperatures compatible with CMOS (450°C or lower), for low germanium concentrations. Polycrystalline layers deposited with PECVD with low stress and low resistivity are described in WO 01/74708, but only at high temperatures (above 550°C).

Slow deposition methods such as CVD (with typical deposition rates of about 5-15 nm/min) can give crystalline layers with low resistivity at 450°C, but this is not an economical process in a single wafer tool for, for instance, 10 $\mu m$ thick layers since the processing time is long. In WO 01/74708 it is indicated that the CVD deposition of in-situ boron doped poly crystalline SiGe at lower temperature (around 400°C) is feasible if the Ge concentration is high enough (above 70%) and if the boron concentration is high enough (above $10^{19}$ /$cm^3$).

## Summary of the invention

The present invention has as an object the development of a deposition process for polycrystalline-SiGe layers and devices therewith while preferably improving stress and/or resistivity and/or speed of deposition.

In one aspect the present invention provides a method of producing a *SiGe* layer on a substrate, said method comprising:

a. depositing onto said substrate a first layer of polycrystalline silicon-germanium ($Si_yGe_{1-y}$) by a non-plasma chemical vapour deposition technique (also called CVD for the purpose of this description) at a temperature T1 and at a rate of less than 10nm/min; and
b. depositing onto said first layer a second layer of polycrystalline silicon-germanium ($Si_zGe_{1-z}$) by plasma enhanced chemical vapour deposition (PECVD) or plasma assisted CVD (PACVD) at a temperature T2 and at a rate of at least 50 nm/min, preferably greater than 100nm/min, said *SiGe* layer being the combination of said first layer and said second layer, wherein said *SiGe* layer is polycrystalline and T1 and T2 ≤ 520°C. Preferably T1 is 300°C or higher. The value of "y" is preferably at least 0.1 (10%).

An embodiment of the above method produces a *SiGe* layer on a substrate, said method comprising:

depositing onto said substrate a first layer of polycrystalline silicon-germanium ($Si_yGe_{1-y}$) by non-plasma chemical vapour deposition (CVD) at a temperature T1; and
depositing onto said first layer a second layer of polycrystalline silicon-germanium ($Si_zGe_{1-z}$) by plasma enhanced or plasma assisted chemical vapour deposition (PECVD or PACVD) at a temperature T2. The *SiGe* layer is the combination of said first layer and said second layer. The *SiGe* layer is preferably polycrystalline and T1 and T2 is preferably ≤ 520°C. The value of "y" is preferably at least 0.1 (10%).

An advantage of the above methods is that a polycrystalline SiGe layer may be deposited at CMOS compatible temperatures, e.g. onto a semiconductor device layer which has been manufactured using CMOS processing.

The method can include depositing a nucleation layer onto said substrate before the deposition of said first layer The nucleation layer may be of silicon or SiGe ($Si_xGe_{1-x}$) deposited at a temperature Tn. Tn is preferably less than or equal to 520°C. The nucleation layer may be amorphous silicon or amorphous SiGe ($Si_xGe_{1-x}$). In a preferred aspect Tn, T1 and T2 are ≤ 500°C For less potential damage to underlying layers of the substrate Tn, T1 and T2 can be ≤ 455°C. In a further preferred aspect x is a function of Tn, y is a function of T1 and z is a function of T2.

In the method Tn can = T1 = T2 = T. Under preferred conditions T can be about 450 °C or less. In preferred embodiments 0.50 ≤ 1-z ≤ 0.70, alternatively 0.60 ≤ 1-z ≤ 0.70.

The PACVD or PECVD can be performed at a pressure between 1 and 10 Torr, for example about 2 Torr. The CVD may be performed at any suitable pressure between low pressure (mTorr) and atmospheric pressure

The plasma power used for the PECVD or PACVD may be between 10 and 100 W, e.g. about 30W. The plasma power density may be in the range 20-200 mW/cm$^2$.

Preferably the *SiGe* layer has an electrical resistance < 10$m\Omega cm$, and a stress σ within the compressive to tensile range of: 20$MPa$ compressive < σ < 100$MPa$ tensile

The present invention also provides a semiconductor device comprising a *SiGe* layer on a substrate obtainable by the method described above. In particular it comprises a substrate with a non-plasma CVD SiGe formed thereon and a PECVD or PACVD SiGe layer formed on the CVD layer. A nucleation layer may be provided between the substrate and the non-plasma CVD layer. The semiconductor device can further comprise a MEMS or a micro-machined device formed in the *SiGe* layer.

The present invention will now be described with reference to the following drawings.

## Brief Description Of The Drawings

Fig. 1 shows sensor locations on the stressmeter for a 6 inch wafer
Fig. 2 shows a Poly-SiGe layer stack in accordance with an embodiment of the present invention
Fig. 3 shows variation of average stress with deposition temperature
Fig. 4 shows variation of average resistivity with deposition temperature.
Fig. 5 shows variation of average resistivity with silane flow rate.
Fig. 6 shows variation of average stress with silane flow rate.
Fig 7: SEM picture of MEMS cantilever constructed in a SiGe layer in accordance with an embodiment of the present invention.

## Description of the invention

The present invention is described in detail below It is apparent, however, that a person skilled in the art can imagine several other equivalent embodiments or other ways of executing the present invention, the spirit and scope of the present invention being limited only by the terms of the appended claims.

A polycrystalline SiGe layer is to be deposited on top of a substrate, e.g. a substrate comprising semiconductor material, at a temperature compatible with the underlying material, e.g the underlying material comprises at least one semiconductor device made by CMOS processing. In embodiments of the present invention, the term "substrate" may include any underlying material or materials that may be used, or contain or upon which a device such as a MEMS device, a mechanical, electronic, electrical, pneumatic, fluidic or semiconductor component or similar, a circuit or an epitaxial layer may be formed. In other alternative embodiments, this "substrate" may include a semiconductor substrate such as e g. a doped silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a $SiO_2$ or an $Si_3N_4$ layer in addition to a semiconductor substrate portion Thus, the term substrate also includes substrates like silicon-on-glass, silicon-on sapphire substrates The term "substrate" is thus used to define generally the elements for layers that underlie a layer or portions of interest. Also, the "substrate" may be any other base on which a layer is formed, for example a glass substrate or a glass or metal layer. In the following processing will mainly be described with reference to processing silicon substrates but the skilled person will appreciate that the present invention may be implemented based on other semiconductor material systems and that the skilled person can select suitable materials as equivalents, as for instance glass substrates

The thickness of the SiGe layer can be 0.5-25 $\mu$m, more preferably 8-12 $\mu$m. Other important concerns are maintaining a low or controlled stress or a low or controlled stress gradient and a low or controlled resistivity in the deposited SiGe films, if possible In accordance with an embodiment of the present invention a polycrystalline SiGe layer is deposited by a combination of Plasma Enhanced Chemical Vapor Deposition (PECVD) or Plasma Assisted Chemical Vapor Deposition (PACVD) and Chemical Vapor Deposition (CVD) processes. The CVD process may be a low pressure up to atmospheric pressure CVD process. The CVD process may be a batch or single wafer process.

The PECVD or PACVD poly-SiGe layers are deposited in a suitable deposition system such as a batch or single wafer system. An example of a suitable system is an Oxford Plasma Technology (OPT) Plasma Lab 100 cold wall system. This consists of two chambers and a central loadlock system. A SiC-covered graphite plate can be used as a carrier for a substrate or semiconductor wafer to avoid contamination at high temperature. The substrate rests on the chuck which is the bottom electrode. The reaction gases are fed into the chamber from the top through the top electrode with integrated shower head gas inlet. A graphite heater heats the chuck to the desired temperature. The calibration for actual wafer temperature can be done in vacuum and at a hydrogen pressure of 2 Torr with a thermocouple wafer, having a number, e.g. seven thermocouples. This system provides the advantage that one system can be used for both low pressure CVD and PECVD The invention is not limited to the use of a single system and includes use of systems and devices dedicated to one of these processing techniques.

For all SiGe depositions, the gas flows were fixed at a suitable rate, e g 166 sccm 10% $GeH_4$ in $H_2$ and 40 sccm 1% $B_2H_6$ in $H_2$. The $SiH_4$ flow rate is varied and the chamber pressure is maintained at a suitable pressure such as 2 Torr. Films are deposited on (100) Silicon wafers covered with an oxide layer, preferably a thermal oxide layer, e.g. a 250nm thick thermal oxide. 10-100W, e.g. 30W of plasma power may be used for the PECVD deposition. For an electrode diameter of ~ 25 cm the plasma power density equals ~ 60 mW/cm$^2$ A suitable plasma power density range is 20-200 mW/cm$^2$. No plasma power is used for the pure low pressure to atmospheric pressure CVD deposition. The CVD deposition is optionally done on top of a nucleation layer As a nucleation layer an amorphous seed layer, e.g. a PECVD deposited seed layer, preferably a PECVD deposited amorphous seed layer can be used in order to avoid large incubation times. This seed layer is not strictly necessary when a time budget is not an issue The incubation time can though form a certain delay in the SiGe layer production: in H.C. Lin, C.Y. Chang, W H. Chen, W.C. Tsai, T.C. Chang, T.G Jung, and H.Y. Lin, 'effects of SiH4, GeH4 and B2H6 on the Nucleation and Deposition of Polycrystalline Si1-xGex Films', J. Electrochem. Soc., Vol 141, No. 9, September 1994, pp 2559-2563, values of incubation times at 550°C and pressures of 0.94 - 1.95 mTorr are disclosed, for undoped poly-Si: 36 minutes , for undoped poly-SiGe: 51 min, B-doped poly-Si: 3' , B-doped poly-SiGe: 2'.

In T-J. King and K.C. Saraswat, 'Deposition and Properties of Low-Pressure Chemical-Vapor Deposited Polycrystalline Silicon-Germanium Films', J Electrochem. Soc, Vol. 141 (8), August 1994, pp2235-2240 it is mentioned that the incubation time rises with decreasing temperature.

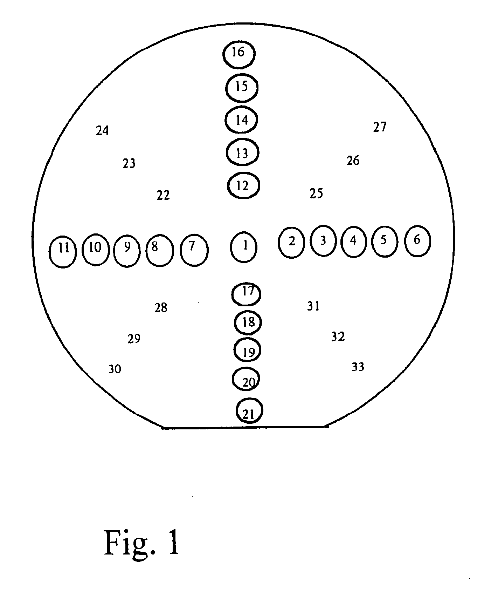

The stress of the SiGe film is measured using a suitable device such as an Eichorn and Hausmann MX 203 stressmeter (Fig.1). It gives the average stress of the film by measuring the bow of the wafer before and after the deposition. The stressmeter has 2x33 sensors, from which 16 local stress values can be measured. For the center stress (Ct), measurements are made on triplets consisting of a center point and two points on the diametrically opposite edges. There are four such triplets on a 6 inch wafer (16-1-21, 24-1-33, 6-1-11, 27-1-30). An average of these values gives the center stress. For the average (Av) stress calculation, triplets are composed of three immediate neighbouring points on a radial line. An average of all such triplets is taken to get the average stress value.

The sheet resistance is measured over the wafer using a suitable probe, e.g. a four point probe Rutherford Backscattering (RBS) measurements can be carried out to measure Si and Ge concentrations in the film.

Any deposited SiGe layer in accordance with the present invention can be processed by any conventional semiconductor or MEMS processing method. For example, photolithography can be carried out to pattern the as-deposited SiGe layers. For example, the SiGe layer can be etched, e.g. in an STS deep dry etching system, which uses an $SF_6+O_2/C_4F_8$ alternating plasma.

Film thickness is measured using a Dektak surface profiler Any underlying sacrificial $SiO_2$ can be removed by a vapour HF etch. Below the results of different state-of-the-art methods are described, followed by the results of a method according to the present invention.

### 1. PECVD OR PACVD AT 520°C

The first series of films were deposited at 520°C (Table 1). PECVD was used to take advantage of the higher growth rates. At 520°C, growth rates up to 140 nm/min were observed. These films had very low resistivity values (0.6-1.0 mΩ-cm) and are expected to be polycrystalline.

**Table 1: Measurement results for PECVD films deposited at 520°C**

| Wafer temp. (°C) | SiH$_4$ flow (sccm) | Power [W] | T$_{deposit}$ (min) | Stress (MPa) | Thick [μm] | Rsheet$_{sq}$ [Ω] | ρ [mΩ-cm] | Ge conc. [%] |
|---|---|---|---|---|---|---|---|---|
| 520 | 30 | 30 | 10 | Ct=+13 Av=+9 | 1.0-1.3 | 4.4-6.6 | 0.6-0.7 | 60 |
| 520 | 50 | 30 | 10 | Ct=-8 Av=-12 | 1.1-1.5 | 4.4-6.6 | 0.6-0.8 | 53 |
| 520 | 70 | 30 | 10 | Ct=-26 Av=-37 | 1.3-1.5 | 4.2-7.4 | 0.6-1.0 | 45 |

However, this temperature can be too high for some processes. For CMOS compatibility normally lower temperatures (e.g. at 450°C or lower) are recommended.

### 2. PECVD 450°C

Boron and phosphorous doped PECVD SiGe films were deposited at 450°C. For the P-doped films, unacceptably high resistivity values ($>10^5 m\Omega cm$) were obtained. Similarly, for B-doped films, a very high compressive stress and large resistivity values were obtained, indicating that the films were not polycrystalline but amorphous in nature.

### 3. CVD 450 °C

CVD films deposited at 450°C had low resistivity values. But, the long deposition time rules out the possibility of using it for thick films (Table 2).

**Table 2: Measurement results for CVD films deposited at 450°C, using an undoped PECVD amorphous Si nucleation layer.**

| Wafer temp. (°C) | SiH$_4$ flow (sccm) | Power [W] | T$_{deposit}$ Minutes | Stress (MPa) | Thick [μm] | Rsheet$_{sq}$ [Ω] | ρ [mΩ-cm] | Ge conc. [%] |
|---|---|---|---|---|---|---|---|---|
| 450 | 30 | 0 | 120 | Ct=-28 Av=-31 | 1.9-2.5 | 2.7-2.8 | 0.6 | 64 |
| 450 | 50 | 0 | 120 | Ct=-103 Av=-105 | 2.1-2.4 | 3.0-3.5 | 0.7 | 55 |

(continued)

| Wafer temp. (°C) | $SiH_4$ flow (sccm) | Power [W] | $T_{deposit}$ Minutes | Stress (MPa) | Thick [$\mu$m] | $Rsheet_{sq}$ [$\Omega$] | $\rho$ [m$\Omega$-cm] | Ge conc. [%] |
|---|---|---|---|---|---|---|---|---|
| 450 | 70 | 0 | 120 | Ct=-167 Av=-160 | 1.8-2.0 | 3.0-4.0 | 0.6-0.7 | 47 |

### 4.CVD+PECVD FILMS AT 450°C

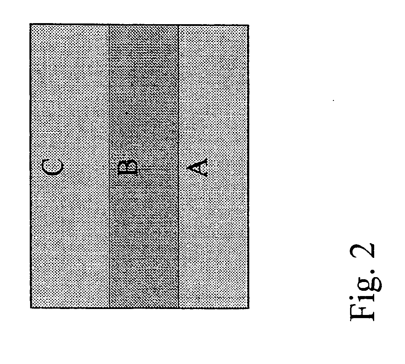

In embodiments of the present invention a combination of both CVD, e.g. low pressure CVD up to atmospheric pressure CVD, and PECVD or PACVD processes is used to obtain polycrystalline films at a low enough temperature (Fig.2). Optionally, a nucleation layer A is deposited, e.g a thin PECVD or PACVD layer is deposited (A, e g ~94nm), to avoid the large incubation time for the growth of SiGe on $SiO_2$ as normally seen in thermal CVD processes. A CVD layer B is deposited on the nucleation layer A. The nucleation layer A is believed to be amorphous and acts as a seed layer for the CVD layer B to be deposited on top (B, e.g ~370nm). This layer B can also have a thickness of for instance 50nm, 60nm, 70nm, 80nm, 90nm, 100nm, 150nm, 200nm, 250nm, 300nm, 350nm. The CVD layer B in its place is a crystallization seed layer for a PECVD or PACVD layer (C, e.g. ~536nm for a total thickness of 1 $\mu$m) deposited on top of the CVD layer B, thus making it possible to obtain a polycrystalline film at low temperatures To reduce processing temperatures it is preferred if the percentage of germanium in the SiGe CVD layer is at least 10%.

Different variations of this process were tried by varying the silane flow rates and deposition temperatures.

A first embodiment of the method for poly-SiGe deposition according to the present invention is described below: a 5 min $H_2$ anneal is followed by a brief PECVD or PACVD deposition at 10-100VV, e.g. 30 W plasma power, to form an optional nucleation layer. A suitable plasma power density range is 20-200 mW/cm$^2$. The gas flows are fixed at suitable rates, e.g. 166 sccm 10% $GeH_4$ in $H_2$, 40 sccm 1% $B_2H_6$ in $H_2$ $SiH_4$ flow rate is varied and the chamber pressure is maintained at 2 Torr. Next, a 20 minute CVD step follows to deposit a CVD layer of e.g. between 50 nm and 450 nm, for instance about 370nm thick Finally, a PECVD or PACVD processing step at 10-100W, e.g. 30 W, is carried out to deposit a PECVD or PACVD layer and to obtain the desired thickness The deposition rate for this step is approximately 113 nm/min. Here the nucleation layer was B-doped SiGe, but any suitable nucleation layer is included within the scope of the present invention. Alternative nucleation layers may be used, e.g undoped SiGe, or doped Si (preferably, but not only, B-doped), or undoped silicon. Each of the layers, meaning nucleation layer, CVD layer and PECVD or PACVD layer can be differently doped (preferably B or P doped) or undoped. Each layer can have a different doping concentration

In a first aspect of the first embodiment of the present invention, the method for forming a poly-SiGe layer was performed at 420, 435 and 450°C. It is clear that for the deposition at 450°C a low stress, low resistivity layer is obtained at a reasonable deposition rate ($39nm$ / min for a total thickness of 1 $\mu$m). This was not possible by the use of PECVD alone The obtained overall or total deposition rate increases even more for thicker films wherein the frac-

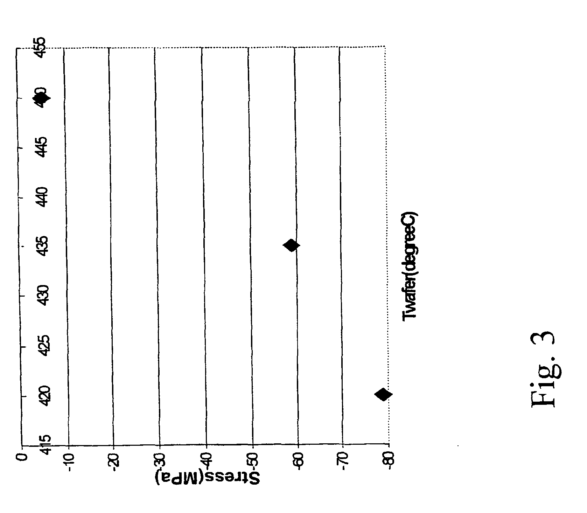

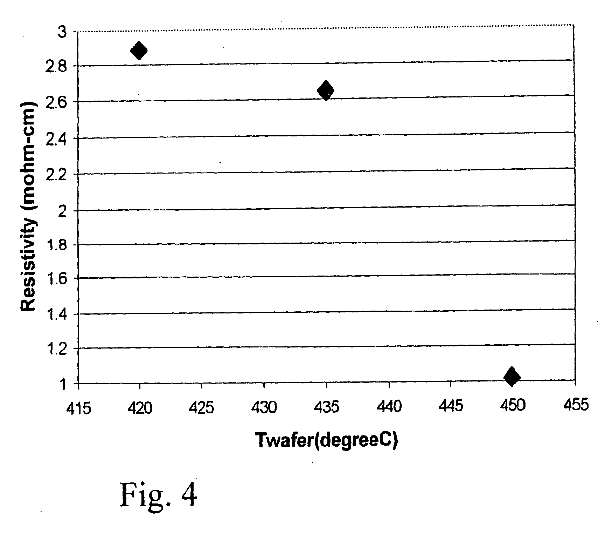

tion $\dfrac{deposition\,time_{PECVD}}{total\,deposition\,time}$ increases. As can be seen in Table 3, the film becomes more compressive and the resistivity values become higher when the deposition temperature is decreased below 450°C, (Fig. 3 and Fig. 4). It is believed, without being limited by theory, that lowering the temperature reduces the crystallinity of films, which is in accordance with the above observations.

**Table 3 CVD+PECVD SiGe films at different deposition temperatures**

| $T_{wafer}$ [°C] | $SiH_4$ [sccm] | Power [W] | Deposition time ' = minutes "= seconds | Thickness [$\mu$m] | Stress [Mpa] | $R_{sheetsq}$ [ohm] | $\rho$ [m$\Omega$-cm] | Ge conc. [%] |
|---|---|---|---|---|---|---|---|---|
| ~420 | 30 | (30+) 0+30 | 50" PECVD nucleation+ 20'CVD + 6' PECVD | 0.9-1.0 | Ct= -72 Av= -79 | 14-45 | 1.4-4.0 | 66 |

(continued)

| T wafer [°C] | SiH4 [sccm] | Power [W] | Deposition time ' = minutes "= seconds | Thickness [μm] | Stress [Mpa] | Rsheetsq [ohm] | ρ [mΩ-cm] | Ge conc. [%] |
|---|---|---|---|---|---|---|---|---|
| ~435 | 30 | (30+) 0+30 | 50" PECVD nucleation+ 20'CVD + 5'30" PECVD | 0.8-1.0 | Ct=-50 Av= -59 | 13-47 | 1.3-3.8 | 66 |
| ~450 | 30 | (30+) 0+30 | 50" PECVD nucleation+ 20'CVD + 5' PECVD | 0.9-1.1 | Ct= -0.6 Av= -5 | 7-13 | 0.8-1.2 | 65 |

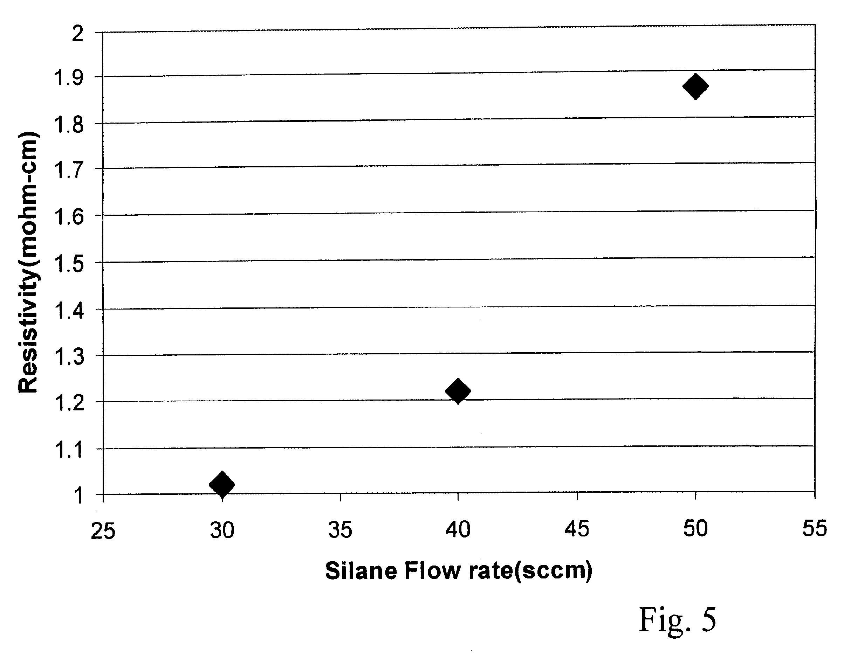

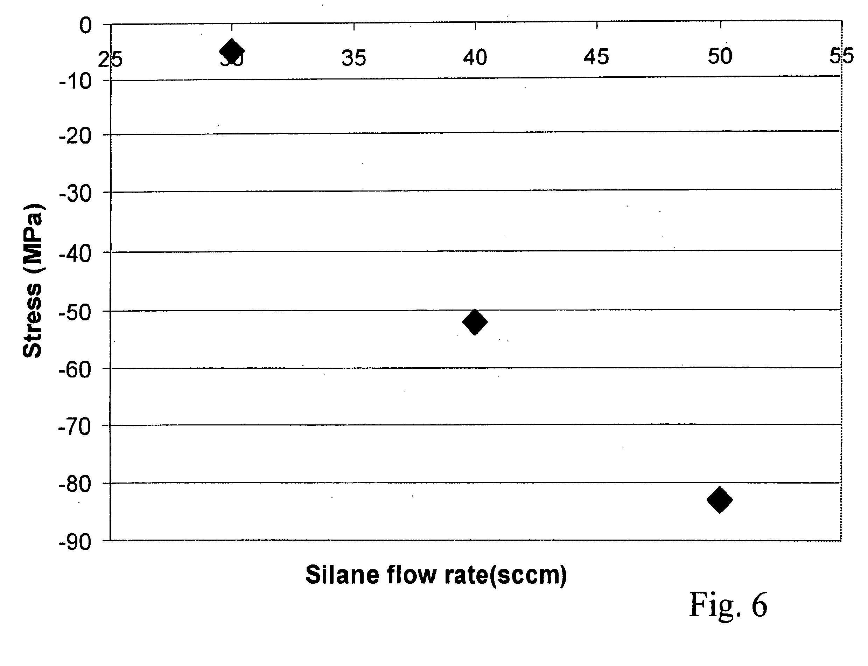

In a second aspect of the first embodiment of the present invention, the method for forming a poly-SiGe layer was performed for differerent silane flow rates (30, 40 and 50 sccm), at a deposition temperature of 450°C (Table 4). As the $GeH_4/SiH_4$ ratio increases, the Ge concentration in the film also increases. The RBS data shows a sharp fall in the germanium concentration with the increase in silane concentration. An increase in Ge concentration reduces the amorphous to crystalline transition temperature, thus it is believed that this increase results in more crystalline films at lower temperatures. It is expected that more crystalline films will have lower resistivity values. This can be clearly observed in Fig 5). Also, the compressive stresses in films increases, as the silane flow increases (see Fig. 6).

**Table 4 CVD+PECVD films at silane flow rates of 30, 40 and 50 sccm**

| T wafer [°C] | SiH4 [sccm] | Power [W] | Deposition time ' = min "= seconds | Thickness [μm] | Stress [MPa] | Rsheetsq [ohm] | ρ [mΩ-cm] | Ge conc. [%] |
|---|---|---|---|---|---|---|---|---|
| ~450 | 30 | (30+) 0 + 30 | 50" PECVD nucleation+ 20' CVD + 5' PECVD | 0.9-1.1 | Ct= -0.6 Av= -5 | 7-13 | 0.8-1.2 | 65 |
| ~450 | 40 | (30+) 0 + 30 | 50" PECVD nucleation+ 20' CVD + 4'48" PECVD | 0.9-1.1 | Ct= -43 Av= -52 | 9-15 | 1.0-1.4 | 60 |
| ~450 | 50 | (30+) 0 + 30 | 50" PECVD nucleation+ 20' CVD + 4'36" PECVD | 0.9-1.1 | Ct= -78 Av= -83 | 11-28 | 1.2-2.5 | 56 |

A second embodiment of the present invention, in view of previous optimisations comprises the following steps:

a 1μm Poly-SiGe film (450°C) can be deposited as follows:

- 5 minutes $H_2$ anneal to ensure temperature uniformity across the wafer.
- 50 seconds PECVD or PACVD flash giving a thin nucleation SiGe layer (~94nm)
- 20 minutes CVD step at 2 Torr with 30 sccm SiH4, 166 sccm 10% $GeH_4$ in $H_2$ and 40 sccm 1% $B_2H_6$ in $H_2$ to form a CVD layer (~370nm)
- 5 minutes PECVD OR PACVD with the same gas flows and pressure, and 10-100W, e.g. 30 W plasma power to form a PECVD or PACVD layer.

The film according to the second embodiment of the present invention shows an average compressive stress of -5 MPa and an average resistivity value of 10$m\Omega cm$. The RBS data shows a Germanium concentration of 65% in the PECVD or PACVD layer.

Table 5 illustrates the relationship between the overall or total deposition time and the fraction *deposition time$_{PECVD}$ /total deposition time,* whereby

$$total\ deposition\ time = deposition\ time_{nucleation\ PECVD} + deposition\ time_{CVD} + deposition\ time_{PECVD}$$

The *deposition time$_{nucleation\ PECVD}$* and the *deposition time$_{CVD}$* were fixed at 50 seconds and 20 minutes respectively.

The obtained overall deposition rate increases for thicker films wherein the fraction $\dfrac{deposition\ time_{PECVD}}{total\ deposition\ time}$ increases.

The deposition process marked with (*) was performed with a PECVD deposited amorphous silicon layer instead of a PECVD SiGe layer. All films have a low resistivity and a low stress, suitable for surface micromachining.

**Table 5: Illustration of the relationship between the fraction *deposition time$_{PECVD}$ /total deposition time* and the deposition rate.**

| PECVD deposition time [min] | Total deposition time ' = min " = seconds | Thickness [$\mu$m ] | Stress [MPa] | $\rho$ [m$\Omega$-cm] | Ge conc. [%] | Deposition rate [nm/ min] |
|---|---|---|---|---|---|---|
| 5' | 25' 50" | 0.9-1.1 | Ct= -0.6 Av= -5 | 0.8-1.2 | 65 | 39 |
| 10'(*) | 30' 50" | 1.5-1.7 | Av= +20 | 0.9-1 | Not measured | 53 |
| 84'24" | 105' 14" | 10-13 | Av= +71 | 0.9 | 64 | 109 |

In Table 6 a comparison chart illustrates again the advantages of the present invention.

**Table 6: Comparison table between state-of-the-art methods (Power=0, 30) and an embodiment of the present invention (power = 0+30).**

| T$_{wafer}$ (°C) | SiH$_4$ [sccm] | Power [W] | T$_{deposit}$ [min] | Stress [MPa] | Thickness [mm] | r [mW.cm] | Crystalline? |
|---|---|---|---|---|---|---|---|
| 450 | 30 | 0(CVD) | 120 | AvS=-31 | 1.9-25 | 0.6 | Yes |
| 450 | 30 | 30 (PECVD) | 10 | AvS~-104 | Not measured | >10E4 | No |
| 450 | 30 | 0+30 | 20+10 | AvS=+20 | 1.5-1.7 | 0.9-1 | yes |

From the above results certain optimised operation conditions are within the scope of the present invention. For example, x can be a function of Tn, y is a function of T1 and z is a function of T2. In the method Tn can = T1 = T2 = T. Under such circumstances T can be about 450 °C. In the method $0.50 \leq 1-z \leq 0.70$, alternatively $0.60 \leq 1-z \leq 0.70$

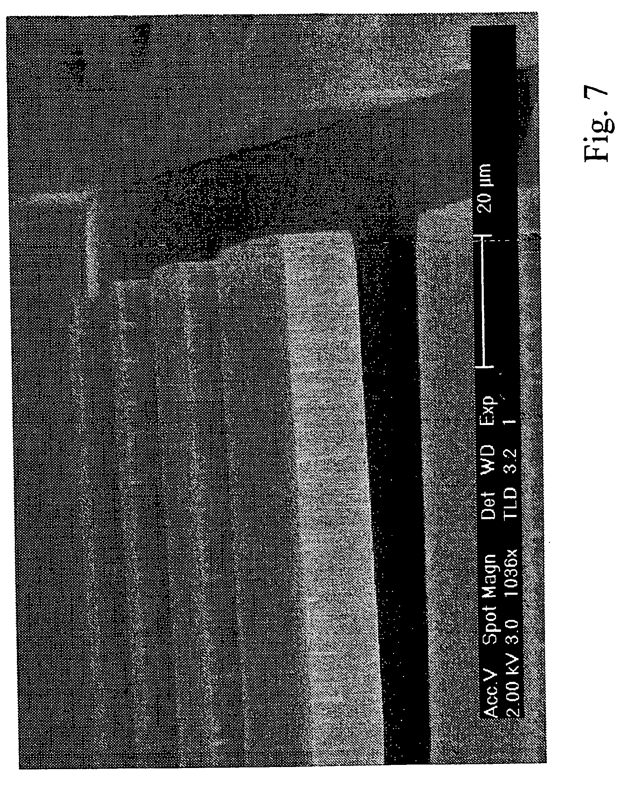

Fig. 7 shows free cantilevers formed in a SiGe layer deposited in accordance with the present invention Such microstructures can be fomed above layers comprising semiconductor active components, e.g as formed by CMOS processing.

**Claims**

1. A method of producing a *SiGe* layer on a substrate, said method comprising:

a. depositing onto said substrate a first layer of polycrystalline silicongermanium ($Si_yGe_{1-y}$) by non-plasma chemical vapour deposition (CVD) at a temperature T1; and

b. depositing onto said first layer a second layer of polycrystalline silicongermanium ($Si_z$-$Ge_{1-z}$) by plasma enhanced chemical vapour deposition (PECVD) or plasma assisted CVD (PACVD) at a temperature T2;

said *SiGe* layer being the combination of said first layer and said second layer, wherein said *SiGe* layer is polycrystalline and T1 and T2 ≤ 520°C.

2. Method according to claim 1, depositing a nucleation layer onto said substrate at a temperature Tn before the deposition of said first layer, Tn being less than or equal to 520°C.

3. Method according to claim 2, wherein the nucleation layer is silicon or SiGe ($Si_xGe_{1-x}$).

4. Method according to claim 1, 2 or 3, with Tn, T1 and T2 ≤ 500°C.

5. Method according to any of claims 1 to 4, with Tn, T1 and T2 ≤ 455°C.

6. Method according to any of claims 1 to 5, wherein x is a function of Tn, y is a function of T1 and z is a function of T2.

7. Method according to any of claims 1 to 6, with Tn = T1 = T2 = T.

8. Method according to claim 7, wherein T is about 450 °C.

9. Method according to claim 8, wherein 0.50 ≤ 1-z ≤ 0.70.

10. Method according to claim 9, wherein 0.60 ≤ 1-z ≤ 0.70.

11. Method according to any of claims 1 to 10 performed at a pressure between 1 and 10 Torr.

12. Method according to any of claims 1 to 11 wherein said plasma power is between 10 and 100 W.

13. Method according to any one of the claims 1 to 12, wherein a plasma power density is in a range 20-200 mW/cm$^2$.

14. The method of any of claims 1 to 13, wherein said *SiGe* layer has an electrical resistance < 10$m\Omega cm$.

15. The method of any of claims 1 to 14, wherein said *SiGe* layer has a stress σ :whereby 20$MPa$ compressive stress < σ < 100$MPa$ tensile.

16. The method of claim 1, wherein said first layer is deposited at a rate of less than 10 mm/min and said second layer is deposited at a rate of at least 50 nm/min , preferably greater than 100 mm/min.

**Patentansprüche**

1. Verfahren zur Herstellung einer SiGe-Schicht auf einem Substrat, wobei das Verfahren umfasst:

a. Abscheiden einer ersten Schicht aus polykristallinem Silizium-Germanium ($Si_yGe_{1-y}$) durch Nicht-Plasma-chemische Dampfabscheidung (CVD) bei einer Temperatur T1; und
b. Abscheiden einer zweiten Schicht aus polykristallinem Silizium-Germanium ($Si_zGe_{1-z}$) auf der ersten Schicht durch plasmaverstärkte chemische Dampfabscheidung (PECVD) oder plasmaunterstützte CVD (PACVD) bei einer Temperatur T2;

wobei die SiGe-Schicht die Kombination aus der ersten Schicht und der zweiten Schicht ist, wobei die SiGe-Schicht polykristallin ist und T1 und T2 ≤ 520°C sind.

2. Verfahren nach Anspruch 1, mit Abscheidung einer Nukleierungsschicht auf dem Substrat bei einer Temperatur Tn vor der Abscheidung der ersten Schicht, wobei Tn kleiner oder gleich 520°C ist.

3. Verfahren nach Anspruch 2, wobei die Nukleierungsschicht Silizium oder SiGe ($Si_xGe_{a-x}$) ist.

**4.** Verfahren nach Anspruch 1, 2 oder 3, wobei Tn, T1 und T2 ≤ 500°C sind.

**5.** Verfahren nach einem der Ansprüche 1 bis 4, wobei Tn, T1 und T2 ≤ 455°C sind.

**6.** Verfahren nach einem der Ansprüche 1 bis 5, wobei x eine Funktion von Tn ist, y eine Funktion von T1 ist und z eine Funktion von T2 ist.

**7.** Verfahren nach einem der Ansprüche 1 bis 6, wobei Tn = T1 = T2 = T.

**8.** Verfahren nach Anspruch 7 wobei T etwa 450°C ist.

**9.** Verfahren nach Anspruch 8, wobei $0{,}50 \leq 1\text{-}z \leq 0{,}70$.

**10.** Verfahren nach Anspruch 8, wobei $0{,}60 \, 9 \, 1\text{-}z \leq 0{,}70$.

**11.** Verfahren nach einem der Ansprüche 1 bis 10, das bei einem Druck zwischen 1 und 10 Torr ausgeführt wird.

**12.** Verfahren nach einem der Ansprüche 1 bis 11, wobei die Plasmaleistung zwischen 10 und 100 W ist.

**13.** Verfahren nach einem der Ansprüche 1 bis 12, wobei eine Plasmaleistungsdichte in einem Bereich von 20 bis 200 $mW/cm^2$ ist.

**14.** Verfahren nach einem der Ansprüche 1 bis 13, wobei die SiGe-Schicht einen elektrischen Widerstand von < 10mΩcm hat.

**15.** Verfahren nach einem der Ansprüche 1 bis 14, wobei die SiGe-Schicht eine Spannung σ hat: wobei 20 MPa Druckspannung < σ < 100 MPa Zugspannung ist.

**16.** Verfahren nach Anspruch 1, wobei die erste Schicht bei einer Rate von weniger als 10 mm/min abgeschieden wird und die zweite Schicht bei einer Rate von mindestens 50 nm/min, vorzugsweise mehr als 100 nm/min abgeschieden wird.

**Revendications**

**1.** Procédé de production d'une couche de *SiGe* sur un substrat, ledit procédé comprenant :

a. le dépôt sur ledit substrat d'une première couche de silicium-germanium polycristallin ($Si_yGe_{1-y}$) par un dépôt chimique en phase vapeur sans plasma (CVD) à une température T1 ; et
b. le dépôt sur ladite première couche d'une seconde couche de silicium-germanium polycristallin ($Si_zGe_{1-z}$) par un dépôt chimique en phase vapeur amélioré au plasma (PECVD) ou un CVD assisté au plasma CVD (PACVD) à une température T2 ;

ladite couche de SiGe étant la combinaison de ladite première couche et de ladite seconde couche, dans laquelle ladite couche de *SiGe* est polycristalline et T1 et T2 ≤ 520 °C.

**2.** Procédé selon la revendication 1, consistant à déposer une couche de nucléation sur ledit substrat à une température Tn avant le dépôt de ladite première couche, Tn étant inférieure ou égale à 520 °C.

**3.** Procédé selon la revendication 2, dans lequel la couche de nucléation est du silicium ou du SiGe ($Si_xGe_{1-x}$).

**4.** Procédé selon la revendication 1, 2 ou 3, avec Tn, T1 et T2 ≤ 500 °C.

**5.** Procédé selon l'une quelconque des revendications 1 à 4, avec Tn, T1 et T2 ≤ 455 °C.

**6.** Procédé selon l'une quelconque des revendications 1 à 5, dans lequel x est une fonction de Tn, y est une fonction de T1 et z est une fonction de T2.

7. Procédé selon l'une quelconque des revendications 1 à 6, avec Tn = T1 = T2 = T.

8. Procédé selon la revendication 7, dans lequel T est d'environ 450 °C.

9. Procédé selon la revendication 8, dans lequel $0,50 \leq 1-z \leq 0,70$.

10. Procédé selon la revendication 9, dans lequel $0,60 \leq 1-z \leq 0,70$.

11. Procédé selon l'une quelconque des revendications 1 à 10 effectué à une pression entre 1 et 10 Torr.

12. Procédé selon l'une quelconque des revendications 1 à 11, dans lequel ladite puissance de plasma est entre 10 et 100 W.

13. Procédé selon l'une quelconque des revendications 1 à 12, dans lequel une densité de puissance de plasma est dans une plage de 20 à 200 mW/cm$^2$.

14. Procédé selon l'une quelconque des revendications 1 à 13, dans lequel ladite couche de SiGe a une résistance électrique < 10 $m\Omega cm$.

15. Procédé selon l'une quelconque des revendications 1 à 14, dans lequel ladite couche de *SiGe* a une contrainte σ : de sorte que 20 *MPa* de contrainte de compression < σ < 100 *MPa* de traction.

16. Procédé selon la revendication 1, dans lequel ladite première couche est déposée à une vitesse de moins de 10 nm/min et ladite seconde couche est déposée à une vitesse d'au moins 50 nm/min, de préférence supérieure à 100 nm/min.

Fig. 1

Fig. 2

Fig. 3

Fig. 4

Fig. 5

EP 1 473 383 B1

Fig. 6

Acc.V Spot Magn Det WD Exp    20 µm
2.00 kV 3.0 1036x TLD 3.2 1

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0174708 A

### Non-patent literature cited in the description

- **A. Witvrouw.** Why CMOS-integrated transducers? A review. *Microsystem Technologies,* 2000, vol. 6 (5), 192-199
- **J. Singh ; S. Chandra.** Strain studies in LPCVD polysilicon for surface micromachined devices. *Sensors and Actuators A (physical),* 1999, vol. A77 (2), 133-8
- **H.C. Lin ; C.Y. Chang ; W H. Chen ; W.C. Tsai ; T.C. Chang ; T.G Jung ; H.Y. Lin.** effects of SiH4, GeH4 and B2H6 on the Nucleation and Deposition of Polycrystalline Si1-xGex Films. *J. Electrochem. Soc.,* September 1994, vol. 141 (9), 2559-2563
- **T-J. King ; K.C. Saraswat.** Deposition and Properties of Low-Pressure Chemical-Vapor Deposited Polycrystalline Silicon-Germanium Films. *J Electrochem. Soc,* August 1994, vol. 141 (8), 2235-2240